Europäisches Patentamt

European Patent Office

Office européen des brevets

(19)

(11) Numéro de publication : **0 148 086**
**B1**

(12) **FASCICULE DE BREVET EUROPÉEN**

(45) Date de publication du fascicule du brevet :
30.09.87

(21) Numéro de dépôt : **84402702.9**

(22) Date de dépôt : **21.12.84**

(51) Int. Cl.⁴ : **H 01 L 27/14, H 01 L 29/78**

(54) Procédé de suppression de charge de fond d'un dispositif photosensible à l'état solide.

(30) Priorité : **27.12.83 FR 8320846**

(43) Date de publication de la demande :
**10.07.85 Bulletin 85/28**

(45) Mention de la délivrance du brevet :
**30.09.87 Bulletin 87/40**

(84) Etats contractants désignés :
**DE GB SE**

(56) Documents cités :
**US-A- 3 969 634**
**IEEE TRANSACTIONS ON ELECTRON DEVICES, vol. ED-29, no. 1, janvier 1982, pages 3-13, IEEE, New York, US; K. CHOW et al.: "Hybrid infrared focal-plane arrays"**
**PATENTS ABSTRACTS OF JAPAN, vol. 7, no. 251 (E-209)[1396], 8 novembre 1983**
**INTERNATIONAL ELECTRON DEVICES MEETING, TECHNICAL DIGEST, 4-6 décembre 1978, Washington, pages 517-521, IEEE, New York, US; P. FELIX et al.: "Readout of a Pb0.80 Sn0.20 Te detector array at 77 K"**

(73) Titulaire : **THOMSON-CSF**
**173, Boulevard Haussmann**
**F-75379 Paris Cédex 08 (FR)**

(72) Inventeur : **Arques Marc Thomson-CSF**
**SCPI - 173, bld Haussmann**
**F-75379 Paris Cedex 08 (FR)**

(74) Mandataire : **Ruellan-Lemonnier, Brigitte**
**THOMSON-CSF SCPI 19, avenue de Messine**
**F-75008 Paris (FR)**

Jouve, 18, rue St-Denis, 75001 Paris, France

## Description

La présente invention concerne les dispositifs photosensibles à l'état solide, plus particulièrement les dispositifs photosensibles à l'état solide fonctionnant en infrarouge.

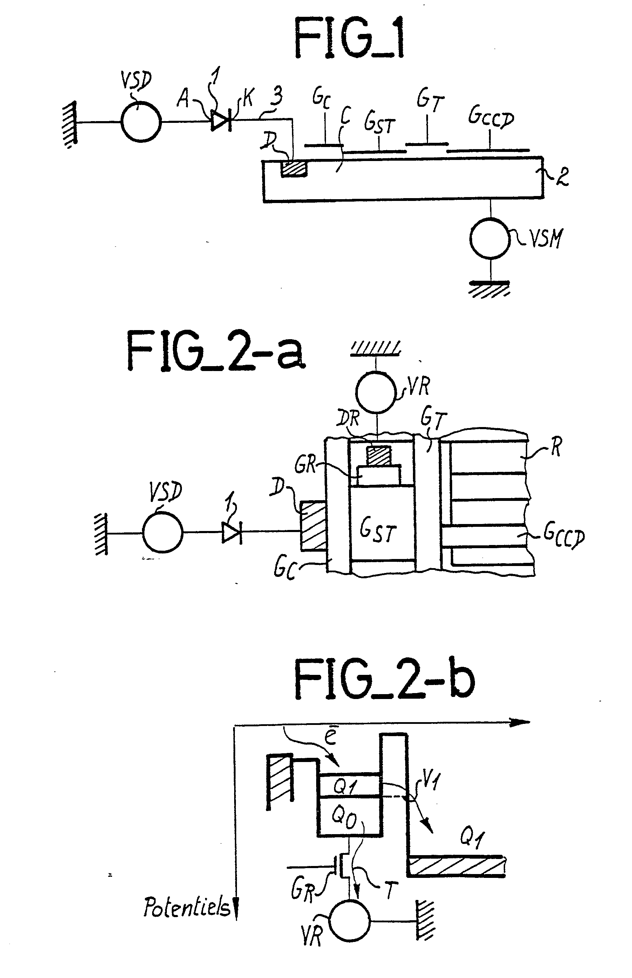

Les dispositifs photosensibles actuellement utilisés sont constitués principalement par un ensemble de N photodétecteurs connectés par l'intermédiaire d'une zone de transition à un multiplexeur constitué de préférence par un registre à décalage à transfert de charge à N entrées parallèles et une sortie série. De manière plus spécifique, et comme représenté sur les figures 1 et 2a qui sont respectivement une vue en coupe transversale et une vue en plan de dessus d'un dispositif photosensible de l'art antérieur constitué principalement par un circuit hybride, à savoir un circuit dans lequel les photodétecteurs sont réalisés sur un premier substrat tandis que la zone de transition et le registre à décalage sont réalisés sur un second substrat 2, les photodétecteurs utilisés sont des photodiodes 1 dont l'anode A reçoit une tension de polarisation $V_{SD}$ tandis que la cathode K est reliée par une connexion à la zone d'intégration des charges. La zone d'intégration des charges comporte une diode de lecture D constituée par une diffusion de type opposé à celui du substrat 2. Cette diode D est reliée par une connexion 3 à la cathode K de la photodiode 1. Une grille de contrôle $G_C$ sépare chaque diode D d'une capacité C de stockage des charges constituée par une grille $G_{ST}$, une couche d'isolant et le substrat. Sur les figures, par souci de clarté, on n'a pas représenté la couche d'isolant qui sépare les diverses grilles de la surface du substrat semiconducteur 2. Une grille de transfert $G_T$ sépare chaque capacité C d'un étage $G_{CCD}$ du registre à décalage à transfert de charge R à entrées parallèles et à sortie série.

Cependant un registre à décalage à transfert de charge présente l'inconvénient d'avoir une possibilité de stockage limitée, ce qui limite, en conséquence, la charge maximale qui peut être transférée à partir des capacités de stockage dans ledit registre.

Ceci est particulièrement gênant dans le cas de l'infrarouge. En effet, dans ce cas on lit des variations de température et l'information utile se superpose à une charge de fond qui peut être relativement importante mais qui est inintéressante au point de vue du signal.

En conséquence, on a proposé d'éliminer au moins une partie de cette charge de fond avant de la transférer dans le registre à décalage. Pour réaliser cette suppression de charge de fond et comme représenté sur la figure 2a, on prévoit sur le côté de chaque grille de stockage $G_{ST}$, une grille $G_R$ et une diffusion $D_R$ de type opposé à celui du substrat reliée à une tension de remise à zéro $V_R$, la grille $G_R$ étant commandée par un potentiel qui est porté à un niveau haut une fois réalisé le transfert des charges dans le registre à décalage, pour remettre à niveau la capacité de stockage correspondante.

On expliquera maintenant le fonctionnement de ce dispositif avec référence à la figure 2b qui représente les potentiels de surface des différents éléments de la figure 2a dans le substrat 2. Pendant l'intégration, les photo-électrons $e^-$ délivrés par la photodiode sont stockés sous la grille de stockage $G_{ST}$. Pendant cette période d'intégration des charges, le transistor MOS T de remise à niveau dont la source induite est constituée par la capacité de stockage, la grille par la grille $G_R$ et le drain par la diffusion $D_R$ est bloqué, à savoir la grille $G_R$ est à un niveau bas. A la fin du temps d'intégration on obtient sous la grille de stockage $G_{ST}$ une quantité de charge Q qui peut être exprimée sous la forme $Q_0 + Q_1$ dans laquelle $Q_0$ désigne la partie de la charge de fond ou piedestal qui peut être éliminée. On abaisse alors la barrière de potentiel sous la grille de transfert $G_T$ jusqu'au niveau $V_1$ indiqué en pointillés sur la figure 2b de façon que la charge $Q_1$ soit transférée sous l'étage $G_{CCD}$ du registre à décalage. On amène ensuite la barrière de potentiel sous $G_R$ à un niveau haut en augmentant la tension de polarisation de cette grille de manière à rendre passant le transistor MOS T de remise à niveau, ce qui permet d'évacuer la charge $Q_0$ vers la tension de remise à zéro $V_R$. Les barrières de potentiel sous les grilles $G_R$ et $G_T$ sont ramenées à un niveau bas et une nouvelle intégration des charges commence.

Ce procédé de suppression de charge de fond présente comme principal inconvénient de nécessiter une grille $G_R$ et une diffusion $D_R$ pour chaque point de couplage photodiode-multiplexeur ainsi que des connexions supplémentaires pour polariser ces deux éléments. Ceci entraîne une augmentation de la surface du circuit de lecture. Un autre inconvénient de ce procédé d'ébasage se situe au niveau de l'électronique de commande qui doit comporter deux tensions de plus et au niveau des connexions qui comportent deux fils de plus.

Un autre procédé de suppression de charge de fond est décrit dans JP-A-58 139 465. Selon ce procédé connu, un potentiel est appliqué au photodétecteur après le stockage de la charge pour augmenter la tension de la diode de lecture et par ce moyen évacuer une charge excédentaire de la zone de stockage vers le photodétecteur sans qu'une structure de drain soit nécessaire. Ensuite, la charge maximale de transfert qui est restée dans la zone de stockage, est transférée dans une ligne de transfert de manière usuelle.

En conséquence, la présente invention a pour but de proposer un nouveau procédé de suppression de charge de fond qui permet de réaliser la même fonction sans compliquer la structure du dispositif photosensible à l'état solide.

La présente invention a pour objet un procédé de suppression de charge de fond pour dispositif photosensible à l'état solide comportant N photodétecteurs réalisés sur un premier substrat et connectés par l'intermédiaire d'une zone de transition comportant au moins une zone de stockage et une grille de transfert et d'un multiplexeur du type à transfert de charge, à un étage de lecture, dans lequel au moins la zone de transition et le multiplexeur sont réalisés sur un second substrat, caractérisé en ce que l'on polarise le second substrat à une tension négative par rapport à celle du premier substrat, puis après avoir réalisé l'intégration des charges et leur transfert dans le multiplexeur de la manière usuelle en laissant une charge $Q_O$ dans la zone de stockage, on polarise la grille de transfert pour le potentiel sous cette grille soit inférieur à la tension de polarisation du premier substrat et la grille de stockage pour que le potentiel sous cette grille soit compris entre la tension de polarisation du premier substrat et le potentiel sous la grille de transfert afin d'évacuer la charge $Q_O$ vers les photodétecteurs.

Pour que l'invention puisse s'appliquer, il est nécessaire de pouvoir polariser différemment le substrat semiconducteur portant les détecteurs et celui portant les zones d'intégration et le multiplexeur.

En conséquence la présente invention s'applique particulièrement bien aux dispositifs photosensibles constitués par un circuit hybride dans lequel le substrat portant les photodétecteurs est indépendant du substrat portant les zones d'intégration. Toutefois, la présente invention peut aussi s'appliquer à un dispositif photosensible réalisé sur un seul substrat semiconducteur. Dans ce cas, la partie du substrat portant les photodétecteurs et celle portant les zones d'intégration et le multiplexeur sont séparées par exemple à l'aide de caissons d'isolement pour pouvoir être polarisées différemment.

D'autres caractéristiques et avantages de la présente invention apparaîtront à la lecture de la description faite ci-après avec référence aux dessins ci-annexés dans lesquels :

la figure 1, déjà décrite, est une vue en coupe transversale d'un dispositif photosensible à l'état solide conforme à l'art antérieur ;

les figures 2a et 2b, déjà décrites, sont respectivement une vue en plan de dessus d'un dispositif photosensible de l'art antérieur comportant au niveau de chaque zone de stockage un moyen d'évacuation des charges pour permettre la mise en œuvre du procédé de suppression de charge de fond actuellement utilisé et la figure 2b représente les potentiels de surface dans le substrat lors de l'utilisation dudit procédé de suppression de charge de fond ;

les figures 3a à 3f sont respectivement une vue en coupe schématique d'un mode de réalisation d'un dispositif photosensible à l'état solide utilisé pour la mise en œuvre du procédé de la présente invention et des schémas montrant l'évolution en fonction du temps des potentiels de surface dans le substrat ;

les figures 4a et 4b sont les caractéristiques tension-courant des photodiodes respectivement lors de l'intégration des charges et lors de l'évacuation de la charge $Q_O$ ;

la figure 5 montre des diagrammes fonction du temps des tensions appliquées sur la grille de transfert $G_T$ et sur la grille $G_{ST}$ de stockage des charges.

Sur les différentes figures les mêmes repères désignent les mêmes éléments, mais pour des raisons de clarté, les cotes et proportions des divers éléments ne sont pas respectées.

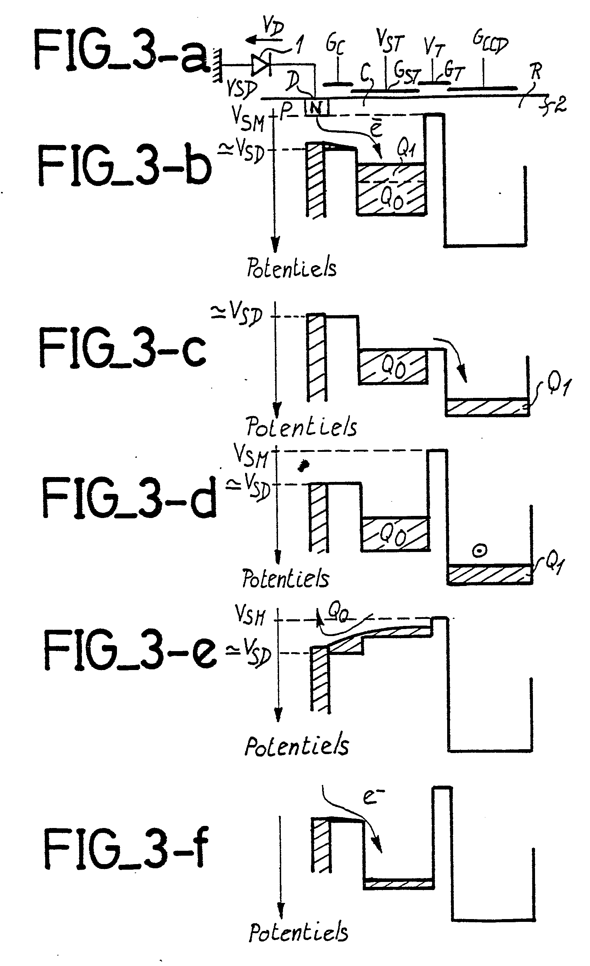

La figure 3a représente une vue en coupe d'un dispositif photosensible utilisé pour la mise en œuvre du procédé de suppression de charge de fond de la présente invention. Ce dispositif photosensible présente une structure identique à un dispositif photosensible de l'art antérieur ne comportant pas de transistor MOS d'évacuation des charges. Le dispositif photosensible de la figure 3a est un circuit hybride, à savoir un circuit dans lequel les photodiodes 1 sont intégrées sur un premier substrat tandis que la zone de transition et le registre de lecture à transfert de charge sont réalisés sur un second substrat. Ce type de circuit est plus particulièrement employé dans le domaine infrarouge. Dans ce cas, le premier substrat sur lequel sont réalisées les photodiodes 1 est constitué, de préférence, par du téllurure de cadmium et de mercure, du tellurure d'étain et de plomb ou de l'antimoniure d'indium.

De même le substrat 2 est de préférence réalisé en silicium de type P dans le cas de photodiodes à anode commune. Toutefois, il pourrait être réalisé en silicium de type N dans le cas de photodiodes à cathode commune ou en tout, autre matériau semiconducteur équivalent tel que l'arséniure de gallium.

Comme représenté sur la figure 3a, le substrat des photodiodes 1 est polarisé à une tension $V_{SD}$ qui, dans le mode de réalisation représenté, est choisie égale à la masse. De même le substrat 2 sur lequel sont réalisés la zone de transition et le registre à décalage à transfert de charge, est polarisé à une tension $V_{SM}$ qui, conformément à la présente invention, est choisie pour être négative par rapport à la tension du premier substrat. Par exemple, la tension $V_{SM}$ peut être choisie égale à 3 Volts. D'autre part, la zone de transition et le registre à décalage sont identiques à la zone de transition et au registre à décalage à transfert de charge du dispositif photosensible représenté à la figure 1. En conséquence la zone de transition comporte, de manière connue, des diodes D constituées par une diffusion de type N réalisée dans le substrat en silicium de type P, une grille de contrôle $G_C$ séparant les diodes D des capacités de stockage des charges C réalisées sous la grille $G_{ST}$ polarisée par une tension $V_{ST}$ et une grille de transfert $G_T$ polarisée par une tension $V_T$ portée alternativement à un niveau haut et à un niveau bas qui sépare la zone de stockage des étages $G_{CCD}$ du registre à décalage R.

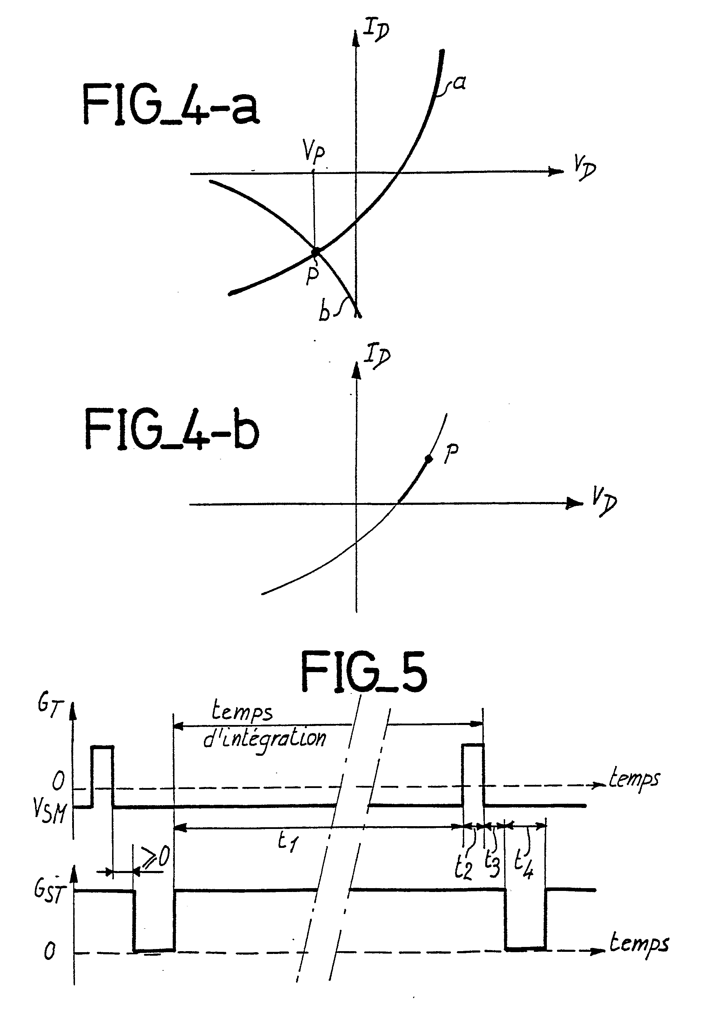

On expliquera maintenant le procédé de suppression de charge de fond conforme à la présente invention avec référence aux figures 3b à 3f, 4a et 4b et à la figure 5. Comme représenté sur la figure 3b et sur la figure 5, pendant le temps $t_1$ on procède à l'intégration des photoélectrons sous la grille de stockage $G_{ST}$. Pendant cette période, la grille de transfert $G_T$ est à un niveau bas, à savoir par exemple, au potentiel $V_{SM}$ du second substrat et la grille de stockage $G_{ST}$ des charges est polarisée au niveau haut. Le fonctionnement est le même qu'avec le procédé de suppression de charge de fond décrit avec référence aux figures 1 et 2. On peut voir sur la figure 4a que le point de fonctionnement P de la photodiode 1 se situe à l'intersection de la caractéristique courant-tension a de la photodiode 1 et de celle b du transistor MOS d'entrée constitué par la diode D, la grille de contrôle $G_C$ et la grille de stockage $G_{ST}$. Habituellement la tension du point de fonctionnement $V_P$ est négative et de l'ordre de quelques dizaines de millivolts.

D'autre part, dans le mode de réalisation représenté, le potentiel sous la grille $G_T$ a été choisi pour être négatif par rapport à la tension de polarisation $V_{SD}$ du premier substrat mais ceci est facultatif. En fait, le potentiel sous la grille de transfert $G_T$ doit être choisi pour être inférieur ou égal à $V_{SD}$.

Pendant le temps $t_2$, on transfert sous la grille $G_{CCD}$ du registre à décalage R, une partie $Q_1$ de la charge intégrée dans la zone de stockage. Pour cela, on porte le potentiel sous la grille de transfert $G_T$ à un niveau haut tel que le potentiel sous $G_T$ soit inférieur au potentiel sous la grille de stockage $G_{ST}$ comme représenté à la figure 3c. La quantité de charges $Q_0$ restant sous la grille de stockage $G_{ST}$ ne dépend donc que des polarisations relatives entre la grille de transfert $G_T$ et les grilles de stockage $G_{ST}$. Ceci correspond à l'opération de suppression de charge de fond.

Comme représenté sur la figure 3d, on ramène ensuite pendant le temps $t_3$ la barrière de potentiel sous la grille $G_T$ à un niveau haut supérieur à la tension $V_{SD}$. La charge $Q_1$ qui a été transférée sous la grille $G_{CCD}$ du registre à décalage peut alors être évacuée par le registre à décalage à transfert de charge vers l'étage de lecture. On abaisse ensuite pendant le temps $t_4$, le potentiel de la grille de stockage $G_{ST}$ de telle sorte que le potentiel qui existerait sous cette grille en l'absence de charge soit compris entre $V_{SD}$ et le potentiel sous la grille de transfert $G_T$, comme représenté à la figure 3e. La charge $Q_0$ est alors refoulée dans les photodiodes 1 dont les points de polarisation se déplacent puisque le courant change de sens dans les photodiodes comme représenté sur la figure 4b. Pour que cette opération soit possible, il est donc nécessaire que l'on puisse établir sous la grille de stockage $V_{ST}$ un potentiel négatif par rapport à la tension de polarisation du premier substrat pour que la charge $Q_0$ puisse retourner sous la photodiode correspondante et que l'on puisse établir sous la grille de transfert $G_T$ un potentiel encore plus négatif pour éviter que $Q_0$ ne soit transférée vers le registre à décalage. Ensuite, comme représenté sur la figure 3f, les polarisations de la grille de stockage $G_{ST}$ et de la grille de transfert sont ramenées aux valeurs qu'elles avaient à la figure 3b et le cycle d'intégration suivant commence.

La présente invention a été décrite en se référant, pour le dispositif photosensible à l'état solide, à un circuit hybride utilisé en particulier dans le domaine de l'infrarouge. Toutefois comme mentionné dans l'introduction, la présente invention peut aussi s'appliquer à un dispositif photosensible réalisé sur un seul substrat semiconducteur dans lequel la partie du substrat sur laquelle sont intégrées les photodiodes est séparée de la partie du substrat sur laquelle sont intégrés la zone de transition et le registre à décalage à transfert de charge par des caissons d'isolement par exemple, pour pouvoir polariser ces deux parties à des tensions différentes. D'autre part, le procédé d'ébasage de la présente invention peut être utilisé dans tous les cas où le signal utile se superpose à une charge de fond ou piedestal quel que soit le rayonnement électromagnétique à détecter.

## Revendications

1. Un procédé de suppression de charge de fond pour un dispositif photosensible à l'état solide comportant N photodétecteurs (1) réalisés sur un premier substrat et connectés par l'intermédiaire d'une zone de transition comportant au moins une zone de stockage réalisée sous une grille de stockage ($G_{ST}$) ainsi qu'une grille de transfert ($G_T$) et d'un multiplexeur (R) du type à transfert de charge, à un étage de lecture, dans lequel au moins la zone de transition et le multiplexeur sont réalisés sur un second substrat (2) caractérisé en ce que l'on polarise le second substrat (2) à une tension ($V_{SM}$) négative par rapport à celle ($V_{SD}$) du premier substrat, puis après avoir réalisé l'intégration des charges et leur transfert dans le multiplexeur de la manière usuelle en laissant une charge $Q_0$ dans la zone de stockage, on polarise la grille de transfert ($G_T$) pour que le potentiel sous cette grille soit inférieur à la tension de polarisation du premier substrat ($V_{SD}$), puis on polarise la grille de stockage ($G_{ST}$) pour que le potentiel sous cette grille soit compris entre la tension de polarisation du premier substrat et le potentiel sous la grille de transfert afin d'évacuer la charge $Q_0$ vers les photodétecteurs (1).

2. Un procédé de suppression de charge de fond selon la revendication 1, caractérisé en ce que le potentiel sous la grille de transfert ($G_T$) pendant l'évacuation de la charge $Q_0$ est choisi égal à la tension de polarisation ($V_{SM}$) du second substrat.

3. Un procédé de suppression de charge de fond selon l'une quelconque des revendications 1 et 2 caractérisé en ce que la tension ($V_{SD}$) du premier substrat est égale à la masse.

4. Un procédé de suppression de charge de fond selon l'une quelconque des revendications 1 à 3, caractérisé en ce que les photodétecteurs, la zone de transition et le registre à décalage sont réalisés sur un même substrat séparé en un premier et un second substrat par des moyens d'isolement.

## Claims

1. Background charge suppression method for a photosensitive solid state device comprising N photodetectors (1) embodied on a first substrate and connected to a reading stage through a transition zone comprising at least one storing zone formed beneath a storing gate ($G_{ST}$) as well as a transfer gate ($G_T$) and a multiplexer (R) of charge transfer type, wherein at least the transition zone and the multiplexer are embodied on a second substrate (2), characterized in that the second substrate (2) is polarized to a negative voltage ($V_{SM}$) with respect to that ($V_{SD}$) of the first substrate, and having performed the integration of the charges and their transfer to the multiplexer in the usual manner leaving a charge $Q_O$ in the storing zone, the transfer gate ($G_T$) is polarized so that the potential of this gate is lower than the polarization voltage of the first substrate ($V_{SD}$), and then the storing gate ($G_{ST}$) is polarized so that the potential beneath this gate is comprised between the polarization voltage of the first substrate and the potential beneath the transfer gate, in order to evacuate the charge $Q_O$ to the photodetectors (1).

2. Background charge suppression method according to claim 1, characterized in that the potential beneath the transfer gate ($G_T$) during evacuation of the charge $Q_O$ is selected equal to the polarization voltage ($V_{SM}$) of the second substrate.

3. Background charge suppression method according to any of claims 1 and 2, characterized in that the voltage ($V_{SD}$) of the first substrate is equal to ground.

4. Background charge suppression method according to any of claims 1 to 3, characterized in that the photodetectors, the transition zone and the shift register are embodied on the same substrate separated in first and second substrates by insulating means.

## Patentansprüche

1. Verfahren zur Unterdrückung der Hintergrundladung für eine photoempfindliche Festkörper-Vorrichtung mit N Photodetektoren (1), die auf einem ersten Substrat gebildet und über eine Übergangszone, die wenigstens eine unter einer Speicherelektrode ($G_{ST}$) sowie einer Überführungselektrode ($G_T$) gebildete Speicherzone enthält, und über einen Multiplexer (R) vom Ladungsüberführungstyp an eine Lesestufe angeschlossen sind, worin wenigstens die Übergangszone und der Multiplexer auf einem zweiten Substrat (2) verwirklicht sind, dadurch gekennzeichnet, daß das zweite Substrat (2) auf eine gegenüber der Spannung ($V_{SD}$) des ersten Substrats negative Spannung ($V_{SM}$) gelegt wird, daß nach der Integration der Ladungen und ihrer Überführung in den Multiplexer in üblicher Weise, wobei eine Ladung $Q_O$ in der Speicherzone verbleibt, die Überführungselektrode ($G_T$) so polarisiert wird, daß das Potential unter dieser Elektrode niedriger als die Polarisationsspannung des ersten Substrats ($V_{SD}$) ist, und daß anschließend die Speicherelektrode ($G_{ST}$) so polarisiert wird, daß das Potential unter dieser Elektrode zwischen der Polarisationsspannung des ersten Substrats und dem Potential unter der Überführungselektrode liegt, um die Ladung $Q_O$ zu den Photodetektoren (1) abzuführen.

2. Hintergrundladung-Unterdrückungsverfahren nach Anspruch 1, dadurch gekennzeichnet, daß das Potential unter der Überführungselektrode ($G_T$) während der Abführung der Ladung $Q_O$ gleich der Polarisationsspannung ($V_{SM}$) des zweiten Substrats gewählt wird.

3. Hintergrundladung-Unterdrückungsverfahren nach Anspruch 1 oder 2, dadurch gekennzeichnet, daß die Spannung ($V_{SD}$) des ersten Substrats gleich Masse ist.

4. Hintergrundladung-Unterdrückungsverfahren nach einem der Ansprüche 1 bis 3, dadurch gekennzeichnet, daß die Photodetektoren, die Übergangszone und das Schieberegister auf demselben Substrat hergestellt werden, das durch Isoliermittel in ein erstes und ein zweites Substrat getrennt wird.

# FIG_1

# FIG_2-a

# FIG_2-b

**0 148 086**

FIG_3-a

FIG_3-b

FIG_3-c

FIG_3-d

FIG_3-e

FIG_3-f

FIG_4-a

FIG_4-b

FIG_5